# EUROPEAN PATENT APPLICATION

(11) **EP 4 764 515 A1**
(43) Date of publication of application: **24.06.2026**
(21) Application number: 25749047.4
(22) Date of filing: 31.01.2025
(51) Int. Cl.: G01R 31/12, G01R 31/327, G01R 31/382, G01R 19/165, G01R 19/12, G01R 19/10

(54) **TEST DEVICE AND TEST METHOD**

(30) Priority: 02.02.2024 KR 20240016809
(71) Applicant: LG Energy Solution, Ltd., Seoul 07335 (KR)
(72) Inventor: AHN, Kwang Hyeon, Daejeon 34122 (KR)
(74) Representative: Goddar, Heinz J.
(86) International application number: PCT/KR2025/001571
(87) International publication number: WO 2025/165144

(57) **Abstract**

A test device according to an embodiment disclosed herein may include a voltage application unit that applies a first voltage and a surge voltage to a relay of a battery, a voltage acquisition unit that acquires a second voltage applied across the relay in response to input of the first voltage, a voltage detection unit that detects a transient section indicating a transient state of the second voltage, and a controller that controls the voltage application unit to apply the surge voltage in the transient section.

## Description

### TECHNICAL FIELD

### Cross-reference to Related Applications

This application claims priority from Korean Patent Application No. 10-2024-0016809, filed on February 2, 2024, in the Korean Intellectual Property Office, the disclosures of which are incorporated by reference herein.

### Technical Field

The embodiments disclosed herein relate to a test device and a test method.

### BACKGROUND ART

In recent years, research and development for secondary batteries have been actively conducted. Here, secondary batteries are batteries capable of being recharged and discharged, and may be interpreted to encompass both conventional Ni/Cd batteries, Ni/MH batteries, or the like, and recent lithium-ion batteries. In recent years, the lithium-ion batteries have expanded their range of use to power sources for electric vehicles, making the batteries attract attention as a next-generation energy storage medium.

In addition, the secondary battery is generally used as a battery pack including a battery module in which a plurality of battery cells are connected in series and/or in parallel. The state and operation of the battery pack are managed and controlled by a battery management system.

Since there is a possibility of fire accidents when using the lithium-ion battery, safety inspections are essential when using the lithium-ion battery. The safety inspections include an overcharge test, a discharge test, an internal short-circuit test, and an electromagnetic compatibility test.

The electromagnetic compatibility test is a test to evaluate the immunity of a device under test (e.g., a battery) to electromagnetic waves. For example, the electromagnetic compatibility test may test the immunity of a device under test (e.g., a battery) to surges by applying a surge voltage to the device under test. In this case, when configuring a circuit for the electromagnetic compatibility test, a test device is connected to a relay included in the device under test. In this case, electrical noise, that is, chattering, occurs during a stage of connecting to a contact point of the relay.

### DISCLOSURE

### TECHNICAL PROBLEM

An object of the embodiments disclosed herein is to provide a test device and a test method capable of testing the immunity of a battery pack or a battery unit to surges.

An object of the embodiments disclosed herein is to provide a test device and a test method capable of controlling a time point to apply a surge depending on a state of a device under test in a surge test of a battery pack or a battery unit.

The technical problems of the embodiments disclosed herein are not limited to those mentioned above, and other objectives not mentioned will be clearly understood by those skilled in the art from the following descriptions.

### TECHNICAL SOLUTION

A test device according to an embodiment disclosed herein includes a voltage application unit that applies a first voltage and a surge voltage to a relay of a battery, a voltage acquisition unit that acquires a second voltage applied across the relay in response to input of the first voltage, a voltage detection unit that detects a transient section indicating a transient state of the second voltage, and a controller that controls the voltage application unit to apply the surge voltage in the transient section.

According to the embodiment, the voltage detection unit may calculate an amount of change in the second voltage per unit time and compare the amount of change with a first threshold value to detect the transient section.

According to the embodiment, the voltage detection unit may determine a section in which the amount of change is greater than the first threshold value as the transient section.

According to the embodiment, the voltage detection unit may calculate a difference value which is a difference between the first voltage and the second voltage and compare the difference value with a second threshold value to detect the transient section.

According to the embodiment, the voltage detection unit may determine a section in which the difference value is greater than the second threshold value as the transient section.

According to the embodiment, the controller may control at least one of a magnitude of the surge voltage, a time point to apply the surge voltage, and the number of times the surge voltage is applied.

According to the embodiment, the first voltage may be a DC voltage.

A test method according to an embodiment disclosed herein includes applying a first voltage to a relay of a battery, acquiring a second voltage applied across the relay in response to input of the first voltage, detecting a transient section indicating a transient state of the second voltage, and applying a surge voltage in the transient section.

According to the embodiment, the detecting of the transient section may include calculating an amount of change in the second voltage per unit time and comparing the amount of change with a first threshold value to detect the transient section.

According to the embodiment, the test method may include determining a section in which the amount of change is greater than the first threshold value as the transient section.

According to the embodiment, the detecting of the transient section may include calculating a difference value which is a difference between the first voltage and the second voltage and comparing the difference value with a second threshold value to detect the transient section.

According to the embodiment, the test method is performed. The test method may include determining a section in which the difference value is greater than the second threshold value as the transient section.

According to the embodiment, the applying of the surge voltage may include determining at least one of a magnitude of the surge voltage, a time point to apply the surge voltage, and the number of times the surge voltage is applied.

According to the embodiment, the first voltage may be a DC voltage.

### ADVANTAGEOUS EFFECTS

A test device and a test method according to the embodiments disclosed herein can test the immunity of a battery pack or a battery unit to surges.

A test device and a test method according to the embodiments disclosed herein can control a time point to apply a surge depending on a state of a device under test in a surge test of a battery pack or a battery unit.

Besides, various effects may be provided that are directly or indirectly identified through the present disclosure.

### BRIEF DESCRIPTION OF THE DRAWINGS

FIG. 1 is a block diagram showing a battery pack according to an embodiment disclosed herein.
FIG. 2 is a graph showing a battery voltage according to the operation of a test device in the related art.
FIG. 3 is a block diagram showing a test device according to an embodiment disclosed herein.
FIG. 4 is a graph showing a first voltage and a second voltage according to an embodiment disclosed herein.
FIG. 5 is a graph showing a surge voltage and the second voltage according to an embodiment disclosed herein.
FIG. 6 is a flowchart showing the operation of the test device according to an embodiment disclosed herein.
FIG. 7 is a block diagram showing a hardware configuration of a computing system for performing a test method according to an embodiment disclosed herein.

### BEST MODE FOR CARRYING OUT THE INVENTION

Hereinafter, various embodiments disclosed in the present invention will be described with reference to the accompanying drawings. However, this is not intended to limit the present invention to the specific embodiments, and it is to be construed to include various modifications, equivalents, and/or alternatives of embodiments of the present invention.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, It is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or via a third element.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the plurality of entities may be disposed separately from other components. According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

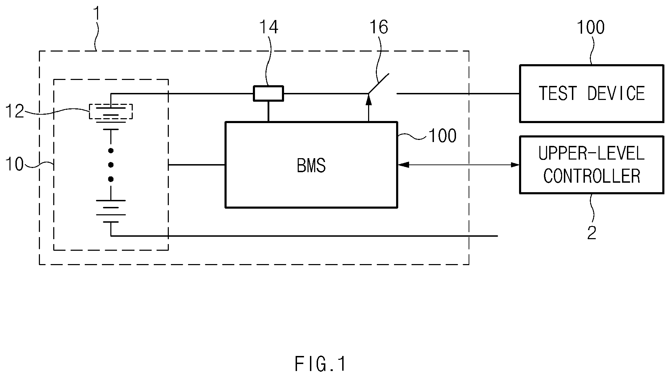

FIG. 1 is a block diagram showing a battery pack according to an embodiment disclosed herein.

Referring to FIG. 1, a battery pack 1 may include a battery unit 10, a sensor unit 14, a switching unit 16, and a battery management system (BMS) 20. In this case, the battery pack 1 may be equipped with a plurality of battery units 10, sensor units 14, switching units 16, and battery management systems 20.

According to the embodiment, the battery unit 10 may supply power to a target device (not shown). For this purpose, the battery unit 10 may be electrically connected to the target device. Here, the target device may include an electrical, electronic, or mechanical device that operates by receiving power from the battery pack 1. For example, the target device may be an electric vehicle (EV) or an energy storage system (ESS), but is not limited thereto.

According to the embodiment, the battery unit 10 may include at least one battery cell 12 that is rechargeable. Here, the battery cell 12 may be a basic unit of a battery cell that may be used by being charged and discharged with electric energy. For example, the battery cell 12 may be a lithium ion (Li-ion) battery, a lithium ion (Li-ion) polymer battery, a nickel cadmium (Ni-Cd) battery, a nickel hydrogen (Ni-MH) battery, or the like, and is not limited thereto.

According to the embodiment, a plurality of battery units 10 may be connected in series or in parallel. For example, the battery unit 10 may be a battery module, a battery bank, or a collection of battery cells (cell-to-pack structure).

According to the embodiment, the sensor unit 14 may acquire information related to the battery unit 10. According to the embodiment, the sensor unit 14 may acquire values (or information) related to a state of each battery unit 10. In an embodiment, the state-related values may include one or more values for voltage, current, resistance, state of charge (SOC), state of health (SOH), or temperature of the battery cell, or a combination thereof.

According to the embodiment, the sensor unit 14 may provide information on each of the plurality of battery units 10 to the battery management system 20.

According to the embodiment, the switching unit 16 may switch the connection between the battery pack 1 and an external device (e.g., a test device 100). For example, the switching unit 16 may switch the electrical connection between the battery pack 1 and an external device (e.g., ports (not shown) provided in the battery pack 1 for connection of the test device 100 and other components included in the battery pack 1 (e.g., the battery unit 10, the battery cell 12, the sensor unit 14, and the BMS 20). Here, the ports provided in the battery pack 1 may include a power port for applying power, a signal port for transmitting an electrical signal, and the like.

According to the embodiment, the switching unit 16 may include a device for controlling the current flow for charging or discharging the battery unit 10. For example, the switching unit 16 may include at least one relay and/or magnetic contactor, depending on the specifications of the battery pack 1.

According to the embodiment, the battery management system (BMS) 20 may control or manage the battery pack 1 to prevent overcharge and overdischarge by monitoring the voltage, current, temperature, and the like of the battery pack 1. For example, the battery management system 20 may be an interface for receiving values obtained by measuring the above-mentioned various parameters, and may include a plurality of terminals, a circuit connected to the terminals to process input values, or the like. In addition, the battery management system 20 may control the sensor unit 14 and/or the switching unit 16. For example, the battery management system 20 may be connected to a plurality of battery units 10 to monitor the state of each of the plurality of battery units 10 and control ON/OFF of the relay, contactor, or the like.

According to the embodiment, the operation of the battery management system 20 may be performed by the BMS (Battery Management System) in a vehicle, as well as by various devices such as a server, cloud, charger, or charger/discharger.

An upper-level controller 2 may transmit a control signal for the plurality of battery units 10 to the battery management system 20. Accordingly, the operation of the battery management system 20 may be controlled based on the signal received from the upper controller 2.

According to the embodiment, the test device 100 may test the operation and/or state of the device under test. Here, the device under test may include the battery pack 1 or the battery unit 10. For example, the test device 100 may refer to a surge test device for testing the immunity of a device under test to surges. Here, surge may refer to a sudden change in voltage, and the surge may occur when electronic devices experience situations such as a blown fuse, lightning, opening of closing of a switch, noise, excessive electromagnetic load, or the like.

The test device 100 according to various embodiments may include a test device specified in the international standard IEC 61000-4-5. For example, the test device 100 may test the immunity of the device under test to surges by applying a voltage and current of a predetermined standard to the device under test.

According to the embodiment, the test device 100 may be connected to a power port or a signal port of the device under test. For example, the test device 100 may apply a surge to a power port or a signal port provided in the battery pack 1.

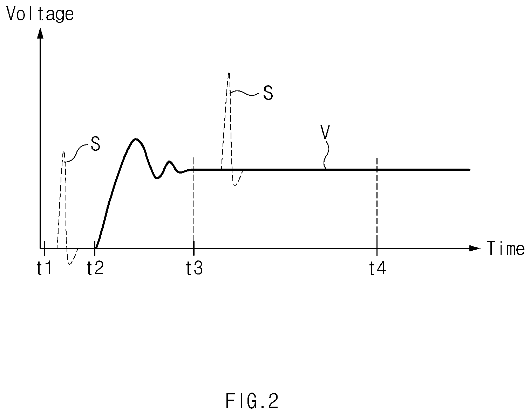

FIG. 2 is a graph showing a battery voltage according to the operation of a test device in the related art.

Referring to FIG. 2, the test device 100 may apply a surge voltage S to the device under test. Here, the surge voltage S may refer to a sudden voltage fluctuation (e.g., a high voltage).

According to the embodiment, since there is no international standard set for the time point and method of applying a surge to a device under test (e.g., the battery pack 1 or the battery unit 10), a tester generally applies the surge voltage S using a surge test device when the device under test is in a normal state. Here, the normal state may refer to a state in which a voltage V of the device under test is in a steady state. For example, the normal state may include a first section t1 to t2 and a second section t3 to t4. Accordingly, the test device 100 may apply the surge voltage S in at least one of the first section t1 to t2 and the second section t3 to t4 in which the voltage V of the device under test is in the normal state.

However, in the actual operating conditions of the device under test, surges may occur in non-normal states (e.g., a transient state). In particular, surges occurring under the transient state of the device under test may have a greater impact on the device under test than surges occurring under the normal state. Therefore, the test device 100 according to the embodiment may apply a surge in the transient state to the device under test in order to test the device under test in a harsher test environment. In this way, the test device 100 may increase the reliability of the surge test.

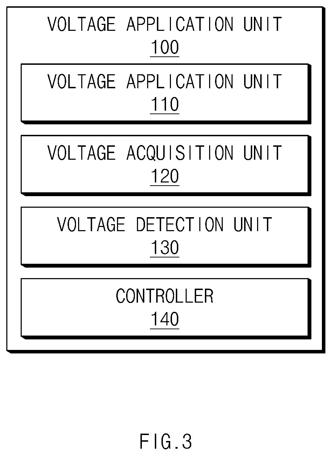

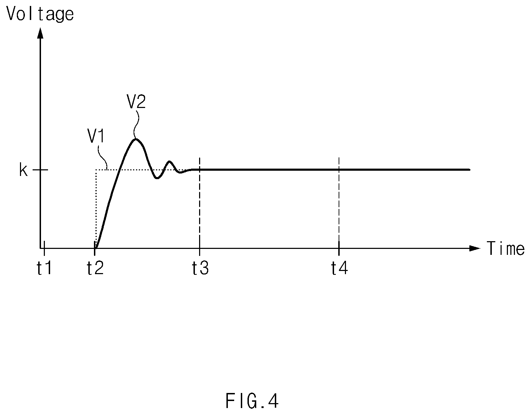

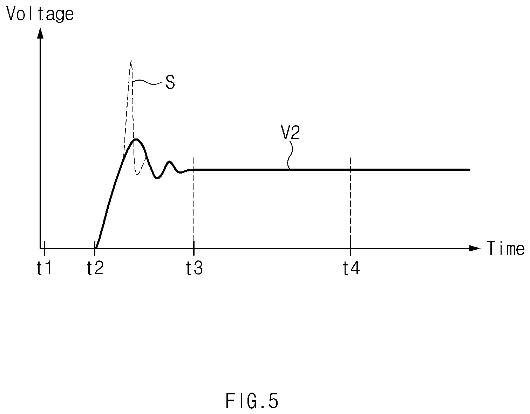

FIG. 3 is a block diagram showing a test device according to an embodiment disclosed herein. FIG. 4 is a graph showing a first voltage and a second voltage according to an embodiment disclosed herein. FIG. 5 is a graph showing a surge voltage and the second voltage according to an embodiment disclosed herein.

Referring to FIGS. 3, 4 and 5, the test device 100 may include a voltage application unit 110, a voltage acquisition unit 120, a voltage detection unit 130 and a controller 140. However, the test device is not limited thereto, and some components may be omitted from the test device 100, and other general-purpose components may be further included in the test device 100.

According to the embodiment, the voltage application unit 110 may apply a voltage to the device under test. Here, the device under test may refer to a battery pack (1, see FIG. 1) or a battery unit (10, see FIG. 1). For convenience of description, the device under test, the battery pack 1, and the battery unit 10 may be collectively referred to as a battery below.

According to the embodiment, the voltage application unit 110 may apply a voltage to the relay of the battery. Here, the relay is a device that switches the electrical connection between the battery and the test device 100, and may refer to, for example, the switching unit 16 illustrated in FIG. 1.

According to the embodiment, the voltage application unit 110 may apply at least one of a first voltage V1 and a surge voltage to the battery. Here, the first voltage V1 may refer to a voltage that operates the battery, and the surge voltage S may refer to a rapid voltage fluctuation (e.g., a high voltage). For example, the surge voltage S may refer to a voltage of a surge waveform having an amplitude and phase specified in Ed3.1 of the international standard IEC 61000-4-5.

According to the embodiment, the first voltage V1 may refer to a direct current (DC) voltage. When the first voltage V1 is an alternating current (AC) voltage, according to Ed3.1 of the international standard IEC 61000-4-5, the test device 100 may apply the surge voltage S at a time point at which a phase of the first voltage V1 is 0°, 90°, 180°, or 270°. However, if the first voltage V1 is a direct current (DC) voltage, there may be no regulations in international standards regarding a method and time point of applying the surge voltage S. Therefore, the test device 100 according to the embodiment may control the timing of applying the first voltage V1 and the surge voltage to the device under test when the first voltage V1 is a DC voltage, thereby optimizing the suitability and reliability of the test.

According to the embodiment, the voltage application unit 110 may apply a voltage of a different specification depending on a port type of the device under test. Here, the port type of the device under test may include a power port for applying power and a signal port for transmitting an electrical signal. For example, when the voltage application unit 110 is connected to the power port of the battery pack 1, the voltage application unit 110 may apply the first voltage V1 of the power specification to the battery pack 1. In addition, when the voltage application unit 110 is connected to the signal port of the battery pack 1, the voltage application unit 110 may apply the first voltage V1 of the signal standard to the battery pack 1.

According to the embodiment, the voltage application unit 110 may be electrically connected to the device under test (e.g., the battery) through a switching unit (16, see FIG. 1) of the device under test. Here, the switching unit 16 may include an element such as an electronic or mechanical switch, a relay, and a field effect transistor (FET).

According to the embodiment, the voltage application unit 110 may include a surge protection circuit. Here, the surge protection circuit may prevent damage to the test device 100 due to the surge voltage S (or signal) and protect the voltage application unit 110. For example, the voltage application unit 110 may include a coupling circuit (Coupling IC). In this way, the test device 100 may be protected from overvoltage or voltage fluctuation due to the surge.

According to the embodiment, the relay of the battery may be short-circuited by the first voltage V1 applied by the voltage application unit 110. Here, when the first voltage V1 is applied to the battery, the relay included in the switching unit 16 may repeat short-circuiting and opening in units of microseconds (ms). In another aspect, when the first voltage V1 is applied to the battery, the relay may experience chattering or bouncing. According to the embodiment, a section in which the relay experiences chattering or bouncing may include a transient section in which the device under test (e.g., the battery) is in a transient state.

According to the embodiment, the voltage acquisition unit 120 may acquire a voltage of the device under test (e.g., the battery). Here, the voltage of the device under test (e.g., the battery) may refer to a second voltage V2 applied across the relay in response to the input of the first voltage V1. Therefore, the second voltage V2 may be different from the first voltage V1.

According to the embodiment, the second voltage V2 may include a transient section in which the device under test (e.g., the battery) is in a transient state and a normal section in which the device under test (e.g., battery) is in a normal state. Here, the transient section may refer to a section immediately after the first voltage V1 is applied to the battery. For example, in the graph of FIG. 4, a section t2 to t3 between a time point t2 at which the first voltage V1 is applied and a time point t3 at which the second voltage V2 converges to the first voltage V1 may refer to the transient section. This transient section t2 to t3 may be accurately detected by the voltage detection unit 130 described below.

According to the embodiment, the voltage detection unit 130 may detect the transient section t2 to t3 indicating a transient state of the second voltage V2. Here, the transient state may refer to a section between a specific normal state t1 to t2 of the second voltage V2 and another normal state t3 to t4.

According to the embodiment, the voltage detection unit 130 may detect the transient section based on the amount of change in the second voltage V2. For example, the voltage detection unit 130 may calculate the amount of change in the second voltage V2 per unit time. Here, the amount of change in the second voltage V2 per unit time may refer to a slope of the graph of the second voltage V2. In addition, the voltage detection unit 130 may compare the amount of change in the second voltage V2 with a first threshold value to detect the transient section.

According to the embodiment, the voltage detection unit 130 may determine a section in which the amount of change in the second voltage V2 is greater than the first threshold value as the transient section. Here, the first threshold value may refer to a reference value for classifying the amount of change in the second voltage V2 as the normal state or the transient state. For example, the first threshold value may be less than 0.1 [unit: V/ms]. According to the embodiment, the smaller the first threshold value, the more accurately the voltage detection unit 130 may detect the transient section. In this way, the voltage detection unit 130 may determine the transient state of the device under test based on the second voltage V2 measured across the relay.

According to the embodiment, the voltage detection unit 130 may detect the transient section based on the first voltage V1 and the second voltage V2. For example, the voltage detection unit 130 may calculate a difference value, which is a difference between the first voltage V1 and the second voltage V2. In addition, the voltage detection unit 130 may compare the difference value with the second threshold value to detect the transient section. In this way, the voltage detection unit 130 may detect a section in which the voltage (the first voltage V1) applied to the relay of the device under test (e.g., the battery) and the voltage measured from the relay (the second voltage V2) are different as the transient section.

According to the embodiment, the voltage detection unit 130 may determine a section in which the difference value is greater than the second threshold value as the transient section. Here, the second threshold value may refer to a reference value for classifying the difference value between the first voltage V1 and the second voltage V2 as the normal state or the transient state. For example, the second threshold value may be less than 0.1 [unit: V]. According to the embodiment, the smaller the second threshold value, the more accurately the voltage detection unit 130 may detect the transient section.

According to the embodiment, the controller 140 may control the operation of the test device 100. For example, the controller 140 may control the operation of the voltage application unit 110, the voltage acquisition unit 120, and the voltage detection unit 130.

According to the embodiment, the controller 140 may control the voltage application unit 110 to control each of the time point to apply the first voltage V1 to the device under test and the time point to apply the surge voltage S to the device under test. For example, the controller 140 may control the voltage application unit 110 to apply the surge voltage S in the normal section t1 to t2 or t3 to t4 or the transient section t2 to t3 of the second voltage V2.

According to the embodiment of FIG. 5, the controller 140 may control the voltage application unit 110 to apply the surge voltage S in the transient section t2 to t3. In this case, the test device 100 may test the reliability of the device under test under more harsh test conditions than when applying the surge voltage S in the normal section t1 to t2 or t3 to t4. Therefore, the test device 100 may test the device under test as to whether to operate even under harsh test conditions, and may increase the reliability of the surge test.

According to the embodiment, the controller 140 may change the surge test conditions by controlling the voltage application unit 110. Here, the surge test conditions may include a magnitude of the surge voltage S, the time point to apply the surge voltage S, and the number of times the surge voltage S is applied. Here, the magnitude of the surge voltage S may refer to an amplitude of the surge voltage S, the time point to apply the surge voltage S may refer to whether the surge voltage S is applied in the transient section or the normal section, and the number of times the surge voltage S is applied may refer to N times of applications (N is a natural number equal to or greater than 1). In this way, the controller 140 may test the device under test under various test conditions.

According to the embodiment, the test device 100 including the controller 140 may diagnose the state of the device under test by analyzing voltage data of the device under test according to the application of the surge voltage S. In addition, when the diagnostic results confirm that the device under test (e.g., the battery) is abnormal, the controller 140 may provide information about the abnormal battery to a user. For example, the controller 140 may provide information about an abnormal battery to a user terminal through a communication unit (not shown), and may also provide the information about an abnormal battery through a display equipped in a vehicle, a charger, or the like.

According to the embodiment, the controller 140 may control the operation of the surge protection circuit included in the voltage application unit 110. According to the embodiment, the controller 140 may control the operation of the surge protection circuit based on a port type of the device under test. For example, when the voltage application unit 110 applies the first voltage V1 (e.g., a signal) to a signal port of the battery, the controller 140 may control the surge protection circuit to operate. In addition, when the voltage application unit 110 applies a first voltage V1 (e.g., the power voltage) to a power port of the battery, the controller 140 may control the surge protection circuit not to operate. In this way, the controller 140 may prevent the surge voltage S applied to the signal port of the device under test (e.g., the battery) from flowing backward to the test device 100. Accordingly, the controller 140 may protect the test device 100 from overvoltage or voltage fluctuation due to surge.

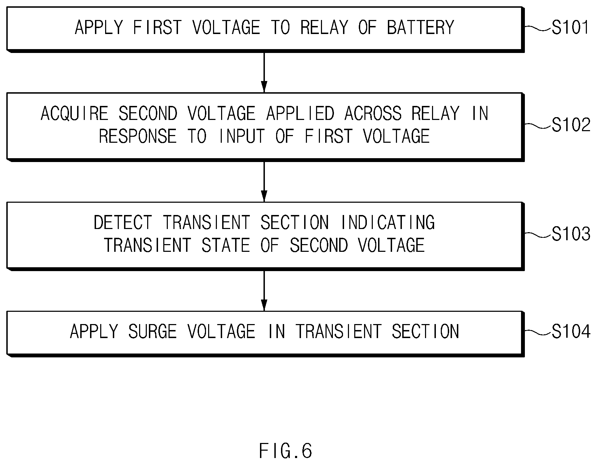

FIG. 6 is a flowchart showing the operation of the test device according to an embodiment disclosed herein.

The operations illustrated in FIG. 6 may be performed through the test device 100 of FIG. 3. Each operation in the following embodiment may be sequentially performed, but is not necessarily sequentially performed. For example, the order of the operations may be changed, and at least two operations may be performed in parallel. In addition, at least one of the following operations may be omitted depending on embodiments.

Referring to FIG. 6, the test device may apply a first voltage to a relay of a battery (S101), acquire a second voltage applied across the relay in response to the input of the first voltage (S102), detect a transient section indicating a transient state of the second voltage (S103), and apply a surge voltage in the transient section (S104).

In operation S101, the voltage application unit 110 of the test device 100 may apply the first voltage to the relay of the battery (S101).

In operation S102, the voltage acquisition unit 120 of the test device 100 may acquire a second voltage applied across the relay in response to input of the first voltage (S102).

In operation S103, the voltage detection unit 130 of the test device 100 may detect the transient section indicating the transient state of the second voltage (S103). According to the embodiment, the voltage detection unit 130 may calculate the amount of change in the second voltage per unit time and detect a section in which the amount of change is greater than a first threshold value as the transient section. In addition, the voltage detection unit 130 may calculate a difference value, which is a difference between the first voltage and the second voltage, and determine a section in which the difference value is greater than a second threshold value as the transient section.

In operation S104, the controller 140 of the test device 100 may control the voltage application unit 110 to apply a surge voltage in the detected transient section (S104).

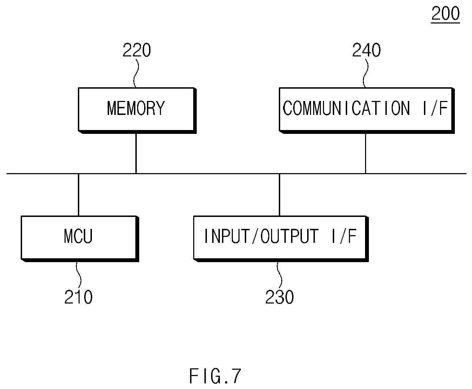

FIG. 7 is a block diagram showing a hardware configuration of a computing system for performing a test method according to an embodiment disclosed herein.

Referring to FIG. 7, a computing system 200 according to an embodiment disclosed herein may include a microcontroller unit (MCU) 210, a memory 220, an input/output interface I/F 230, and a communication I/F 240.

The MCU 210 may be a processor that executes various programs (e.g., a battery data collection program, a data analysis program, a data processing program, and the like) stored in memory 220, processes various information including battery data through the programs, and performs the functions of the test device 100 shown in FIGS. 1 to 6 described above.

The memory 220 may store various programs such as the battery data collection program, the data analysis program, the data processing program, and the like.

A plurality of memories 220 may be provided as needed. The memory 220 may be a volatile memory or a non-volatile memory. As the volatile memory, the memory 220 may be a random access memory (RAM), a dynamic RAM (DRAM), a static RAM (SRAM), or the like. For the memory 220 as the non-volatile memory, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 220 listed above are only exemplary and the computing system is not limited to the examples.

The input/output I/F 230 may provide an interface that enables data to be transmitted and received by connecting an input device (not illustrated) such as a keyboard, mouse, or touch panel, and an output device (not illustrated) such as a display and the MCU 210.

The communication I/F 240 is a component that may transmit and receive various data to and from the server, and may be any device that may support wired or wireless communication. For example, the test device 100 may transmit and receive various types of information, including battery data, to and from a separately provided external server through the communication I/F 240.

By being recorded in the memory 220 and processed by the MCU 210 in this way, a computer program according to an embodiment disclosed herein may be implemented, for example, as a module that performs each of the functions shown in FIG. 2.

Although all the components constituting the embodiments disclosed herein have been described as being combined or operating in combination as one, the embodiments disclosed herein are not necessarily limited to these embodiments. That is, within the scope of the purpose of the embodiments disclosed herein, all of the components may be selectively combined and operated one or more times.

Terms such as "include," "comprise," or "have" described above mean that the corresponding component can be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The foregoing disclosure outlines features of several embodiments so that those skilled in the art may better understand the aspects of the present disclosure. Those skilled in the art will appreciate that the present disclosure may readily serve as a basis for designing or modifying other structures for carrying out the same purposes or achieving the same advantages of the embodiments introduced herein. Furthermore, those skilled in the art will recognize that such equivalent configurations do not depart from the scope of the present disclosure, and that various changes, substitutions, and modifications may be made herein without departing from the scope of the present disclosure.

### (Reference Signs List)

1: Battery pack
2: Upper-level controller
10: Battery unit
12: Battery cell
14: Sensor unit
16: Switching unit
20: Battery Management System (BMS)
100: Test device
110: Voltage application unit
120: Voltage acquisition unit
130: Voltage detection unit
140: Controller
200: Computing System
210: MCU
220: Memory
230: Input/output I/F
240: Communication I/F.

## Claims

1. A test device comprising:
a voltage application unit that applies a first voltage and a surge voltage to a relay of a battery;
a voltage acquisition unit that acquires a second voltage applied across the relay in response to input of the first voltage;
a voltage detection unit that detects a transient section indicating a transient state of the second voltage; and
a controller that controls the voltage application unit to apply the surge voltage in the transient section.

2. The test device of claim 1, wherein the voltage detection unit
calculates an amount of change in the second voltage per unit time, and
compares the amount of change with a first threshold value to detect the transient section.

3. The test device of claim 2, wherein the voltage detection unit determines a section in which the amount of change is greater than the first threshold value as the transient section.

4. The test device of claim 1, wherein the voltage detection unit
calculates a difference value which is a difference between the first voltage and the second voltage, and
compares the difference value with a second threshold value to detect the transient section.

5. The test device of claim 4, wherein the voltage detection unit determines a section in which the difference value is greater than the second threshold value as the transient section.

6. The test device of claim 1, wherein the controller controls at least one of a magnitude of the surge voltage, a time point to apply the surge voltage, and the number of times the surge voltage is applied.

7. The test device of claim 1, wherein the first voltage is a direct current (DC) voltage.

8. A test method comprising:
applying a first voltage to a relay of a battery;
acquiring a second voltage applied across the relay in response to input of the first voltage;
detecting a transient section indicating a transient state of the second voltage; and
applying a surge voltage in the transient section.

9. The test method of claim 8, wherein the detecting of the transient section includes:
calculating an amount of change in the second voltage per unit time; and
comparing the amount of change with a first threshold value to detect the transient section.

10. The test method of claim 9, comprising determining a section in which the amount of change is greater than the first threshold value as the transient section.

11. The test method of claim 8, wherein the detecting of the transient section includes:
calculating a difference value which is a difference between the first voltage and the second voltage; and
comparing the difference value with a second threshold value to detect the transient section.

12. The test method of claim 11, comprising determining a section in which the difference value is greater than the second threshold value as the transient section.

13. The test method of claim 8, wherein the applying of the surge voltage includes determining at least one of a magnitude of the surge voltage, a time point to apply the surge voltage, and the number of times the surge voltage is applied.

14. The test method of claim 8, wherein the first voltage is a DC voltage.
